# EUROPEAN PATENT APPLICATION

(11) **EP 2 474 998 A1**
(43) Date of publication of application: **11.07.2012**
(21) Application number: 10813731.6
(22) Date of filing: 01.09.2010
(51) Int. Cl.: H01L 21/027, G03F 7/20

(54) **COATING MATERIAL COMPOSITION FOR LIQUID IMMERSION EXPOSURE APPARATUS, LAMINATE, METHOD FOR FORMING LAMINATE, AND LIQUID IMMERSION EXPOSURE APPARATUS**

(30) Priority: 01.09.2009 JP 2009202017
(71) Applicant: Asahi Glass Company, Limited, Tokyo 100-8405 (JP)
(72) Inventor: TAKEBE Yoko, Tokyo 100-8405 (JP); YOKOKOJI Osamu, Tokyo 100-8405 (JP)
(74) Representative: Müller-Boré & Partner Patentanwälte
(86) International application number: PCT/JP2010/064925
(87) International publication number: WO 2011/027782

(57) **Abstract**

The present invention relates to a coating material composition for a liquid immersion exposure apparatus, which is used for the purpose of forming a lyophobic layer on a surface of a component member of the liquid immersion exposure apparatus which performs a light exposure of a substrate by irradiating with an exposure beam through a liquid, in which the composition contains a fluorine-containing polymer which has, in the main chain, a repeating unit that has a fluorine-containing aliphatic ring structure containing two or three etheric oxygen atoms which are not adjacent to each other, in the ring structure.

## Description

### Field of the Invention

The present invention relates to a coating material composition for a liquid immersion exposure apparatus, which is used for the purpose of forming a lyophobic layer on a surface of a component member of various sensors of the liquid immersion exposure apparatus, a lyophobic laminate formed, a method for forming a laminate, and a liquid immersion exposure apparatus. The laminate includes not only a multilayered structure of two or more layers, but a single layer.

### Background Art

A lithography method comprising irradiating a mask with a light of an exposure light source to project a pattern image of the mask obtained to a photosensitive resist on a substrate, and transferring the pattern image to the photosensitive resist, is used in the production of an integrated circuit such as a semiconductor. In general, the pattern image of a mask is projected to a desired position of a photosensitive resist through a projector lens which relatively moves upper the photosensitive resist.

In recent years, a liquid immersion lithography method utilizing the phenomenon that a wavelength of light in a liquid medium becomes times of the reciprocal of a refractive index of the liquid medium is studied. The liquid immersion lithography method is an exposure method of projecting a pattern image of a mask to a photosensitive resist on a substrate through a projector lens in the state that a space between the lower part of the projector lens and the upper part of the photosensitive resist is filled with a liquid medium such as water.

In the case that ArF excimer laser (wavelength: 193 nm) is used as an exposure light source in the liquid immersion lithography method, a space between a projector lens and a photosensitive resist is constantly filled with a liquid medium (pure water) having high refractive index and high light permeability. Therefore, a film (water repellent film) having water repellent function is formed on a surface of an optical element substrate (lens element) in order to prevent penetration of water in ambient environment. For example, fluorine-based materials such as polytetrafluoroethylene, acrylic resin materials, or silicon-based resin materials are used as the water repellent film. In particular, use of a cyclic perfluoro resin is proposed to form a water repellent film having high permeability to ArF excimer laser (for example, see Patent Document 1).

Furthermore, it is reported that, in such a liquid immersion exposure apparatus, a water repellent film is formed on a surface of an alignment optical component member having a possibility of contacting pure water which is a liquid medium, for example, a component member such as various sensors provided on a substrate stage holding a substrate and a measurement stage mounting a photoelectric sensor. The water repellent film which is formed on the surface of such a component member is required to have not only water repellency, but high light resistance in the presence of pure water. Specifically, because an alignment optical component member is irradiated with ArF excimer laser which is an exposure beam during exposure and during measuring, it is required that water repellency is not deteriorated even though receiving high energy irradiation in the presence of pure water.

However, durability of the conventional water repellent film comprising a cyclic perfluoro resin has not always been sufficient. For this reason, it is necessary to frequently replace a component member having a water repellent film provided thereon. Because the operation of the whole liquid immersion exposure apparatus is stopped during the replacement, this gave remarkable influence to productivity. On the other hand, because ArF excimer laser having high energy is widely used as an exposure light source, a water repellent layer for a liquid immersion exposure apparatus has been required to have high water repellency and further have durability (irradiation resistance) capable of maintaining water repellency under high energy over a long period of time. However, the present situation is that a water repellent material sufficiently satisfying such requirements is not yet known.

### Prior Art References

### Patent Document

Patent Document 1: JP-A 2007-235088A

### Summary of the Invention

### Problems that the Invention is to Solve

The present invention has been made to solve the above problems, and has an object to provide a coating material composition for a liquid immersion exposure apparatus, which is used for the purpose of forming a lyophobic layer having excellent liquid repellency, particularly dynamic liquid repellency, and excellent irradiation resistance in the presence of a liquid medium.

### Means for Solving the Problems

The present inventors have made keen investigations to obtain a material capable of forming a layer at low temperature, in which the layer formed has excellent liquid repellency, particularly dynamic liquid repellency, high permeability of ArF excimer laser, and excellent irradiation resistance in the presence of a liquid medium of a liquid immersion exposure apparatus. As a result, they have found a material having such excellent properties.

That is, the coating material composition for a liquid immersion exposure apparatus according to the present invention is a composition which is used for the purpose of forming a lyophobic layer on a surface of a component member of the liquid immersion exposure apparatus which performs a light exposure of a substrate by irradiating with an exposure beam through a liquid, in which the composition comprises a fluorine-containing polymer which has, in the main chain, a repeating unit that has a fluorine-containing aliphatic ring structure containing two or three etheric oxygen atoms which are not adjacent to each other, in the ring structure.

The laminate according to the present invention is a laminate formed on a surface of a component member of a liquid immersion exposure apparatus which performs a light exposure of a substrate by irradiating with an exposure beam through a liquid, in which the laminate comprises a fluorine-containing polymer which has, in the main chain, a repeating unit that has a fluorine-containing aliphatic ring structure containing two or three etheric oxygen atoms which are not adjacent to each other, in the ring structure.

The method for forming a laminate according to the present invention is a method for forming a laminate on a surface of a component member of a liquid immersion exposure apparatus which performs a light exposure of a substrate by irradiating with an exposure beam through a liquid, the method comprising: a step of applying a pre-treatment to the surface of the component member; a step of forming a second layer containing a fluorine-containing polymer having at least one functional group on the surface of the component member having been subjected to the pre-treatment; and a step of forming a first layer on the second layer by applying the coating material composition for a liquid immersion exposure apparatus according to the present invention.

The liquid immersion exposure apparatus according to the present invention is an apparatus which performs a light exposure of a substrate by irradiating with an exposure beam through a liquid, and comprises the laminate according to the present invention on a surface of a component member.

### Advantages of the Invention

According to the present invention, a coating material composition capable of forming a layer at low temperature and capable of forming a layer having good liquid repellency, particularly dynamic liquid repellency, high permeability of an exposure beam such as ArF excimer laser and excellent irradiation resistance, can be obtained. By using the coating material composition, a lyophobic layer having good dynamic liquid repellency, high permeability of an exposure beam and excellent irradiation resistance can be formed on a surface of a component member, particularly various sensors of alignment optical system and measurement stage, of a liquid immersion exposure apparatus. As a result, liquid immersion lithography method can be carried out in a stable manner. Furthermore, because the lyophobic layer has excellent durability, a component member is not required to replace over a long period of time, and the number of maintenance can be reduced.

### Brief Description of the Drawing

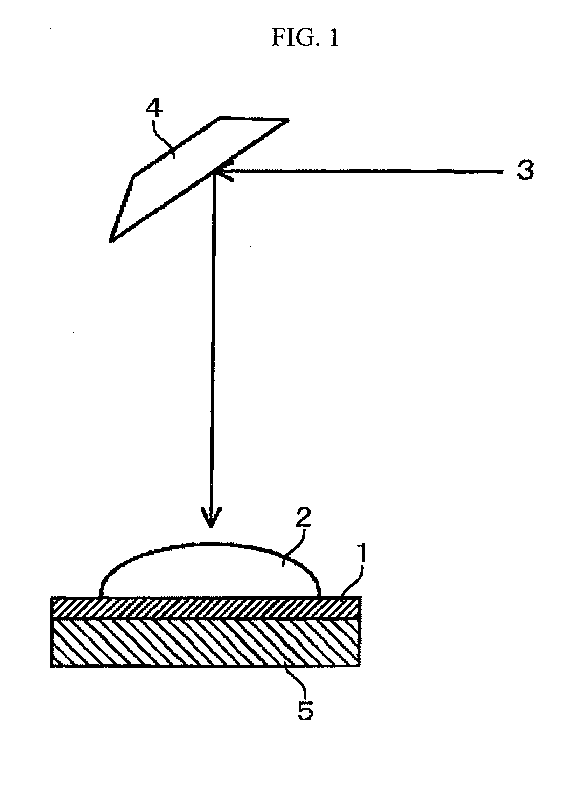

[FIG.1] Fig. 1 is a view schematically showing an evaluation method of irradiation resistance to laser light in Examples of the present invention.

### Mode for Carrying out the Invention

The embodiment of the present invention is described below. In the present description, a compound represented by the formula (a) is also indicated as compound (a), and a repeating unit represented by the formula (A) is also indicated as unit (A). Compounds and repeating units represented by other formulae are similarly indicated.

The coating material composition of the present invention is a composition used for the purpose of forming a lyophobic layer on the surface of a component member in a liquid immersion exposure apparatus that performs a light exposure of a substrate by irradiating with an exposure beam through a liquid. The coating material composition contains a fluorine-containing polymer (B) which contains, in the main chain, a fluorine-containing aliphatic ring structure containing two or three etheric oxygen atoms which are not adjacent to each other in the ring structure, as a repeating unit.

In the present invention, the phrase "containing two or three etheric oxygen atoms which are not adjacent to each other in the ring structure" means a structure that two or three etheric oxygen atoms are bonded through one or two carbon atoms without being adjacent to each other, and constitute a ring. The term "aliphatic ring structure" means a saturated or unsaturated ring structure. A five-membered ring or six-membered ring structure is preferred, and a saturated aliphatic five-membered or six-membered ring structure is particularly preferred. The term "fluorine-containing aliphatic ring structure" means a structure that a fluorine atom or a fluorine-containing group is bonded to at least a part of carbon atoms constituting a main skeleton of a ring. The phrase "contains, in the main chain, a fluorine-containing aliphatic ring structure as a repeating unit" means that at least one carbon atom constituting the fluorine-containing aliphatic ring is a carbon atom in a carbon chain constituting the main chain.

The fluorine-containing polymer (B) is preferably a perfluoro resin having a dioxole structure. A polymer containing at least one of a repeating unit (B1) derived from a fluorine-containing compound represented by the following formula (b1) (that is, compound (b1)), and a repeating unit (B2) derived from a fluorine-containing compound represented by the following formula (b2) (that is, compound (b2)) is further preferred. A polymer containing both the repeating units (B1) and (B2) can be used. In the present invention, the term "repeating unit derived from a compound" means a repeating unit formed by polymerization of the compound.

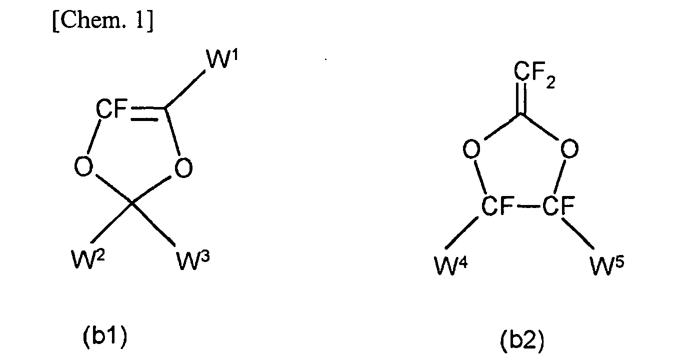

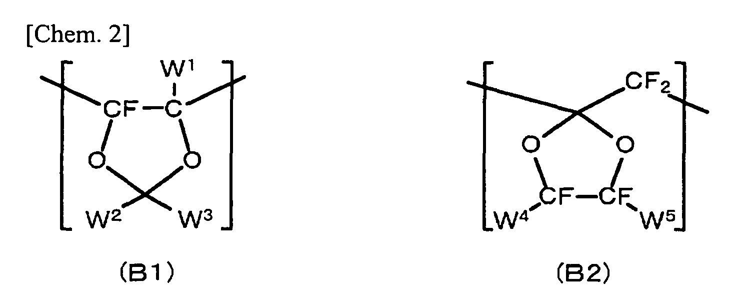

In the above formulae, W¹ represents a fluorine atom, a perfluoroalkyl group having from 1 to 3 carbon atoms, or a perfluoroalkoxy group having from 1 to 3 carbon atoms. W² and W³ each independently represent a fluorine atom, or a perfluoroalkyl group having from 1 to 6 carbon atoms, which may contain an oxygen atom. In the above formulae, W² and W³ may form a cyclic structure. Examples of the cyclic structures formed by W² and W³ include a six-membered ring containing two etheric oxygen atoms. W⁴ and W⁵ each independently represent a fluorine atom, or a perfluoroalkyl group having from 1 to 8 carbon atoms, which may contain an oxygen atom. In the above formulae, W⁴ and W⁵ may form a cyclic structure. Examples of the cyclic structures formed by W⁴ and W⁵ include a five-membered ring containing one etheric oxygen atom, and a six-membered ring free of an etheric oxygen atom.

The repeating unit (B1) particularly preferred in durability (irradiation resistance over a long period of time) is that W¹ is a fluorine atom, and W² and W³ each are a perfluoromethyl group having one carbon atom. The repeating unit (B2) particularly preferred in durability is that one of W⁴ and W⁵ is a fluorine atom, and the other is a perfluoromethyl group having one carbon atom.

Specific examples of the fluorine-containing compound (b1) include perfluoro(2,2-dimethyl-1,3-dioxole) (PDD) represented by the following formula (b1-1).

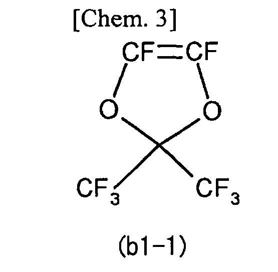

Other examples include compounds represented by the following formulae (b1-2) to (b 1-4).

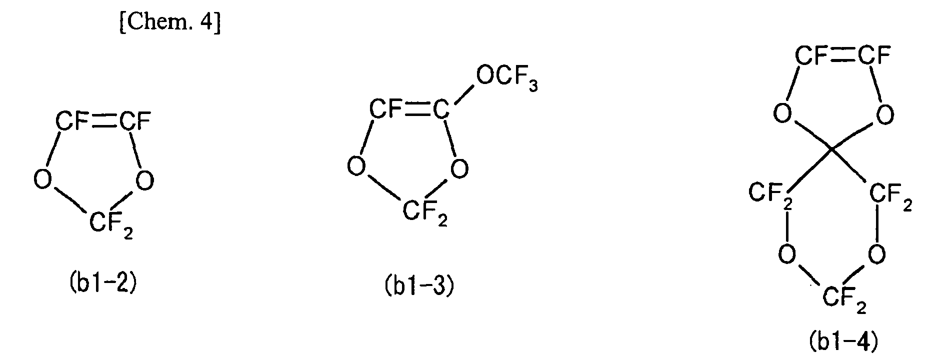

Further, specific examples of the compound (b2) include perfluoro(2-methylene-1,3-dioxolane) represented by the following formula (b2-1) and perfluoro(2-methylene-4-methyl-1,3-dioxolane) (MMD) represented by the following formula (b2-2).

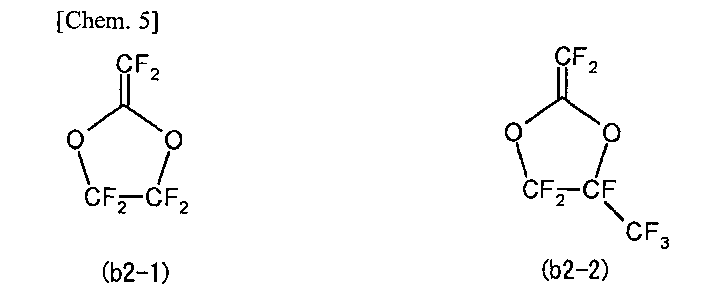

The fluorine-containing polymer (B) may be any of a homopolymer, a copolymer or a mixture of a homopolymer and a copolymer.

The polymer (B) preferably contains at least one of the repeating unit (B1) and the repeating unit (B2) in an amount of 10 mol% or more based on all repeating units. In the case of containing both (B1) and (B2), the total amount of the repeating unit (B1) and the repeating unit (B2) is preferably 10 mol% or more. The repeating unit (B1) may consist of one kind of the repeating unit represented by the above formula (B1), and may contain two kinds thereof. Furthermore, the repeating unit (B2) may consist of one kind of the repeating unit represented by the above formula (B2), and may contain two kinds thereof.

Furthermore, the polymer (B) may be a polymer consisting of only the repeating unit (B1) and the repeating unit (B2), but may be a polymer containing a repeating unit other than the repeating unit (B1) and the repeating unit (B2) (hereinafter referred to as "other repeating unit"). The polymer (B) preferably contains the repeating unit (B1) or the repeating unit (B2) in an amount of 10 mol% or more based on all repeating units, and particularly preferably contains the same in an amount of 50 mol% or more. In the case of containing both (B1) and (B2), the total amount of the repeating unit (B1) and the repeating unit (B2) is preferably 10 mol% or more, and particularly preferably 50 mol% or more. In the case that the polymer (B) contains other repeating unit, the content of the other repeating unit is preferably 90 mol% or less, and particularly preferably 50 mol% or less, based on all repeating units.

Examples of other monomer of copolymerization (comonomer) include perfluoroalkylene having 4 or 6 fluorine atoms (for example, tetrafluoroethylene (TFE)) and perfluorovinyl ether (for example, perfluorobutenylvinyl ether (BVE)). The other repeating unit constituting the polymer (B) is preferably a repeating unit (C) derived from tetrafluoroethylene (TFE) or a repeating unit (D) derived from a compound represented by the following formula (d1) or formula (d2).

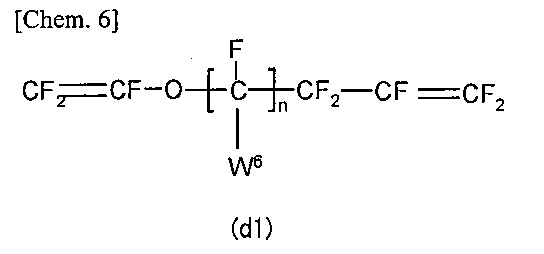

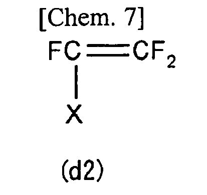

In the formula (d1), W⁶ represents a fluorine atom or a perfluoroalkyl group having from 1 to 3 carbon atoms. n is 0 or 1. In the formula (d2), X represents a perfluoroalkyl group having from 1 to 8 carbon atoms, or a perfluoroalkoxy group having from 1 to 8 carbon atoms. In the case that the polymer (B) contains a repeating unit derived from the compound of the above formula (d1) or formula (d2), toughness can be imparted to a lyophobic layer obtained from the composition containing the polymer (B).

The polymer (B) can be synthesized by, for example, homopolymerizing the fluorine-containing compound (b1) or the fluorine-containing compound (b2), or copolymerizing the fluorine-containing compound (b1) and the fluorine-containing compound (b2). The polymer (B) can further be obtained by copolymerizing the fluorine-containing compound (b1) and/or the fluorine-containing compound (b2) with tetrafluoroethylene (TFE) or the compound represented by the formula (d1) or (d2).

Radial polymerization is preferably used as the polymerization method. The means of the radical polymerization is not limited so long as the polymerization proceeds radically, and examples thereof include polymerization by organic or inorganic radical polymerization initiator, light, ionizing radiation or heat. The method of polymerization can use bulk polymerization, solution polymerization, suspension polymerization and emulsion polymerization. The weight average molecular weight (Mw) of the polymer (B) is preferably a range of from 100,000 to 500,000.

The coating material composition of the present invention preferably contains a fluorine-containing organic solvent which dissolves the fluorine-containing polymer (B) (hereinafter referred to as a "fluorine-based organic solvent"). The fluorine-based organic solvent is not particularly limited so long as it dissolves the fluorine-containing polymer (B). For example, a perfluoro compound can be used. Specific examples of the perfluoro compound include perfluorotributylamine, perfluorotripropylamine, perfluorotripentylamine, perfluorooctane, perfluorodecane, perfluorohexane, perfluorobenzene, perfluoro-2-butyltetrahydrofuran, and perfluorodecaline. Specific examples of the fluorine-based organic solvent other than the perfluoro compound include decafluoro-3-methoxy-4-trifluoropentane, 1-ethoxy-nonafluorobutane, 1-methoxy-nonafluorobutane, 1,1,2,2-tetrafluoroethyl-2,2,2-trifluoroethyl ether, 1-hydrotridecafluorohexane, nonafluorohexane, 1,1,2,2,3,3,4-heptafluorocyclopentane, methyltridecafluorohexyl ether, 1,1,1,2,2-pentafluoro-3,3-dichloropropane, and 1,1,2,2,3-pentafluoro-1,3-dichloropropane.

The concentration of the fluorine-containing polymer (B) in the composition containing the fluorine-containing organic solvent is preferably from 1 to 13 % by mass. A water repellent layer having a desired thickness can be obtained by controlling the concentration of the fluorine-containing polymer (B).

The lyophobic layer containing the fluorine-containing polymer (B) can be formed by applying the coating material composition of the present invention to the surface of a component member, evaporating the fluorine-containing organic solvent and drying. Other fluorine-based polymer may be added to the coating material composition of the present invention in order to impart toughness to the lyophobic layer. Examples of the other fluorine-based polymer include polymers containing the repeating unit (C) derived from tetrafluoroethylene (TFE) and polymers containing the repeating unit (D) derived from the compound represented by the formula (d1) or (d2).

The coating material composition of the present invention can be applied to component members of any shape and any material. As described hereinafter, it is preferred that a layer of the fluorine-containing polymer (A) having a functional group is formed on the surface of a component member of a liquid immersion exposure apparatus, and a lyophobic layer is formed by further applying the coating material composition of the present invention thereto, thereby forming a laminate having a multilayer structure of two or more layers. Examples of the application method include spin coating, dip coating, spray coating and potting. Spin coating is preferably used. The thickness of the lyophobic layer can be adjusted by, for example, adjusting the concentration of the fluorine-containing polymer in the composition, the number of rotations of spin coating or lifting speed in dip coating. Drying temperature of the fluorine-containing organic solvent is appropriately selected depending on a heat resistant temperature of the substrate, and is preferably from 50 to 250°C, and more preferably from 100 to 200°C. Thickness of the lyophobic layer is preferably from 0.05 µm to 3 µm, and more preferably from 0.1 µm to 1.5 µm.

The lyophobic layer containing the fluorine-containing polymer (B) has high permeability to an exposure beam (for example, ArF excimer layer) used in a liquid immersion exposure apparatus, and has good liquid repellency (particularly, dynamic liquid repellency) to a liquid used in a liquid immersion exposure apparatus. In the liquid immersion exposure apparatus, pure water is preferably used as the liquid.

Light permeability to ArF excimer layer of the lyophobic layer containing the fluorine-containing polymer (B) is preferably 90% or more, and more preferably 95% or more. The lyophobic layer further preferably has extremely high liquid repellency such that a receding contact angle to pure water is 95° or more. Furthermore, the lyophobic layer has excellent property of having light resistance in the case of being irradiated with an exposure beam through a liquid (for example, pure water) and maintaining high liquid repellency even in ArF excimer layer irradiation.

The laminate of the present invention is formed as a single layer or as a multilayer of two or more layers on the surface of a component member of the liquid immersion exposure apparatus, and has the lyophobic layer (first lyophobic layer) formed using the composition of the present invention. Thickness of the first lyophobic layer is a range of preferably from 0.05 µm to 3 µm, and further preferably from 0.1 µm to 1.5 µm. The laminate of the present invention may be a single layer containing only the first lyophobic layer, but is preferably a laminate of two or more layers, containing the first lyophobic layer.

The laminate of the present invention preferably has the first lyophobic layer on a surface layer of a second lyophobic layer containing the fluorine-containing polymer (A) having a functional group. The fluorine-containing polymer (A) having a functional group preferably has high permeability to an exposure beam (for example, ArF excimer laser) used in the liquid immersion exposure apparatus, and has an effect of adhering the first lyophobic layer containing the polymer (B) having a fluorine-containing aliphatic ring structure to a component member of the liquid immersion exposure apparatus. Examples of the fluorine-containing polymer (A) include cyclic perfluoro polymers having a functional group. The functional group is preferably a carboxyl group (-C(O)OH), an amide group (-C(O)NH₂), a hydroxyl group (-OH), an amino group (-NH₂), a cyano group (-CN), a sulfo group (-SO₃H) and a mercapto group (-SH), each having a polarity. The fluorine-containing polymer (A) is preferably cyclic perfluoro polymers having the functional group at a side chain site or a terminal site of the polymer structure, and is particularly preferably one having the functional group at the terminal site.

The cyclic perfluoro polymer having a functional group includes CYTOP A, manufactured by Asahi Glass Company, Limited. Thickness of the second lyophobic layer is preferably from 50 nm to 300 nm, and further preferably from 100 nm to 200 nm.

To form the second lyophobic layer, a method of pre-treating the surface of a component member of a liquid immersion exposure apparatus, applying a composition prepared by dissolving the cyclic perfluoro polymer having a functional group in a fluorine-containing organic solvent (fluorine-based organic solvent) thereto, and evaporating the fluorine-containing organic solvent, followed by drying can be employed. The pre-treatment is preferably a silane coupling treatment or a corona discharge treatment. A silane coupling agent used in the pre-treatment is preferably an alkoxysilane-based coupling agent, and particularly preferably γ-aminopropyltrimethoxysilane (H₂NC₃H₆Si(OC₂H₅)₃). Examples of the application method of the composition include spin coating, dip coating, spray coating and potting. Spin coating is particularly preferred. Drying temperature of the fluorine-containing organic solvent is appropriately selected depending on a heat resistant temperature of the component member, and is preferably from 50 to 250°C, and more preferably from 100 to 200°C. Specific examples of the fluorine-based organic solvent include the compounds described hereinbefore.

The laminate of the present invention can be formed by forming a lyophobic layer (first lyophobic layer) on the surface of the second lyophobic layer using the composition containing the fluorine-containing polymer (B). An intermediate layer having high permeability to an exposure beam (for example, ArF excimer layer) and stress relaxation function can be formed between the second lyophobic layer and the first lyophobic layer. The intermediate layer preferably has the effect of further increasing adhesion between the second lyophobic layer and the first lyophobic layer. Material constituting the intermediate layer includes CYTOP S, manufactured by Asahi Glass Company, Limited. Thickness of the intermediate layer is a range of preferably from 0.05 µm to 3 µm and further preferably from 0.1 µm to 1.5 µm.

The laminate of the present invention is formed on the surface of the component member having a possibility of contacting a liquid in the liquid immersion exposure apparatus which performs a light exposure of a substrate by irradiating with an exposure beam (for example, ArF laser beam) through a liquid. Pure water is preferably used as the liquid. Examples of light source of the exposure beam include g-line (wavelength: 436 nm), i-line (wavelength: 365 nm), KrF excimer laser light (wavelength: 248 nm), ArF excimer laser light (wavelength: 193 nm), and F₂ excimer laser light (wavelength: 157 nm). ArF excimer laser light or F₂ excimer laser light is preferred, and ArF excimer laser light is particularly preferred.

Examples of the component member on which the laminate is formed include various sensors provided on a substrate stage which holds a substrate and a measurement stage which mounts a photoelectric sensor. The surface of the component member may be constituted of quartz or glass, and may be constituted of a metal such as iron, SUS, copper, aluminum, chromium or gold. Furthermore, it may be constituted of a resin such as polymethyl methacrylate (PMMA), polycarbonate (PC), polystyrene (PS) or polysulfone (PSF).

In liquid immersion exposure step which performs a light exposure of a substrate by irradiating with an exposure beam through a liquid, exposure is carried out while supplying a liquid to a space between a projection optical system and a substrate. To improve productivity, exposure scanning rate must be increased. The lyophobic layer is formed on the surface of the component member such as various sensors provided on a substrate stage which holds a substrate (for example, base plate) or on a measurement stage which mounts a photoelectric sensor. The lyophobic layer is required to have high dynamic water repellency which can hold a liquid in a space between the projection optical system and the base plate even though the stage moves in high speed. Specifically, the lyophobic layer preferably has high dynamic water repellency such that a receding contact angle in a tilt measurement method is 90° or more, and more preferably 95° or more.

On the other hand, various sensors provided on the substrate stage and the measurement stage are irradiated with an exposure beam (for example, ArF excimer laser light) through a liquid during exposure and during sensor measurement. Therefore, the lyophobic layer formed on the surface of the component member such as various sensors requires that surface properties of the lyophobic layer do not change even though receiving high energy irradiation in the presence of a liquid (pure water), that is, high dynamic water repellency is maintained. Specifically, it is preferred that the lyophobic layer has high dynamic water repellency such that a receding contact angle in a tilt measurement method is 90° or more, and more preferably 95° or more even after irradiation of ArF excimer laser light in a constant dose (0.5 kJ/cm²) through pure water.
In this case, the tilt measurement method is a method of forming water droplet of 50 µl on a substrate having a surface on which the corresponding material has been applied, and measuring a contact angle and the like of the water droplet while stepwise inclining the substrate. The angle of the substrate from a horizontal plane when the water droplet slides out of the substrate is called a sliding angle (dynamic sliding angle), a contact angle at the front side of the water droplet to the sliding down direction at that time is called an advancing contact angle, and a contact angle at the back side is called a receding contact angle (dynamic receding angle). In the present invention, DM-700 manufactured by Kyowa Interface Science Co., Ltd. was used as the measurement instrument.

### Examples

The present invention is specifically described below by reference to Examples, but it should not be construed as being limited to those Examples.

### Examples 1 to 34 and Comparative Examples 1 and 2

### [Production of Water Repellent Composition (Perfluoro Polymer Solution)]

Fluorine-containing monomers (A, B, E, F, I and O) represented by the following formulae A, B, E, F, I and O were copolymerized with other monomer components (TFE, BVE and PPVE) in the compositions (molar ratio) shown in Table 1 to synthesize perfluoro polymer Nos. 1, 2, 4, 8, 10, 14 to 17 and 24, respectively. TFE indicates tetrafluoroethylene, BVE indicates perfluorobutenylvinyl ether, and PPVE indicates perfluoropropylvinyl ether.

Synthesis of perfluoro polymer Nos. 2, 16, 17 and 24 was conducted as follows. In a pressure vessel, 0.8 g of the fluorine-containing monomer A, I or O, 0.8 g of other monomer component BVE or PPVE, and 0.08 g of 1H-perfluorohexane as a solvent were charged, and 0.34 g of bis(heptafluorobutylyl) peroxide (PFB) as a polymerization initiator was added thereto. The bis(heptafluorobutylyl) peroxide (PFB) was added as a 3 % by mass of R-225(1,1,1,2,2-pentafluoro-3;3-dichloropropane) solution. The inside of the system was evacuated, and then polymerization was conducted in a thermostatic chamber at 40°C for 3 hours. After the polymerization, the reaction solution was added dropwise to methanol to reprecipitate a polymer, and the polymer was dried in vacuum at 100°C for 12 hours and at 200°C for 1 hour. Heat treatment was further conducted at 300°C for 1 hour to obtain 0.7 g of a polymer. Molecular weight of the polymer obtained was obtained as a limiting viscosity by a viscosity method (measurement method: 30°C) using 1,1,1,2,2,3,4,5,5,5- decafluoro-3-methoxy-4-trifluoromethylpentane as a solvent, and the viscosity [η] obtained was 0.2 dl/g.

Synthesis of perfluoro polymer Nos. 1, 4, 8, 10, 14 and 15 was conducted as follows. In a pressure vessel, 1.5 g of the fluorine-containing monomer A, B, E, F or I, and 21.7 g of R-225 as a solvent were charged, and 0.83 g of PFB (3 % by mass of R-225 solution) was added as a polymerization initiator. After the inside of the system was evacuated, 1 g of TFE was added, and polymerization was conducted in a thermostatic chamber at 40°C for 3 hours. After the polymerization, the reaction solution was added dropwise to methanol to reprecipitate a polymer, and the polymer was dried in vacuum at 100°C for 12 hours and at 200°C for 1 hour. Heat treatment was further conducted at 300°C for 1 hour to obtain 2.1g of the polymer. The limiting viscosity [η] thereof was 0.33 dl/g.

Fluorine-containing monomers (B to P) represented by the formulae B to P each were homopolymerized to synthesize perfluoro polymer Nos. 3, 5 to 7, 9, 11 to 13, 18 to 23, and 25, respectively. The synthesis of those perfluoro polymers was conducted as follows. In a pressure vessel, 0.8 g of the respective fluorine-containing monomers (B to P), and 0.28 g of 1H-perfluorohexane as a solvent were charged, and 0.09 g of PFB (3 % by mass of R-225 solution) as a polymerization initiator was then added thereto. After the inside of the system was evacuated, polymerization was conducted in a thermostatic chamber at 40°C for 3 hours. After the polymerization, the reaction solution was added dropwise to methanol to reprecipitate a polymer, and the polymer was dried in vacuum at 100°C for 12 hours and at 200°C for 1 hour. Heat treatment was further conducted at 300°C for 1 hour to obtain 0.63 g of the polymer. The limiting viscosity [η] thereof was 0.22 dl/g.

BVE was homopolymerized in the same manner as above to synthesize perfluoro polymer No. 26.

The perfluoro polymer Nos. 1 to 26 obtained each were dissolved in perfluorotributylamine and filtered with a filter (made of polyether sulfone) having a pore size of 1.0 µm to obtain 9 to 11% by mass of uniform water repellent composition Nos. 1 to 26. A solution of the perfluoro polymer No. 13 was prepared in the same manner as above, and a 3 to 4 % by mass of uniform water repellent composition No. 13' was obtained.

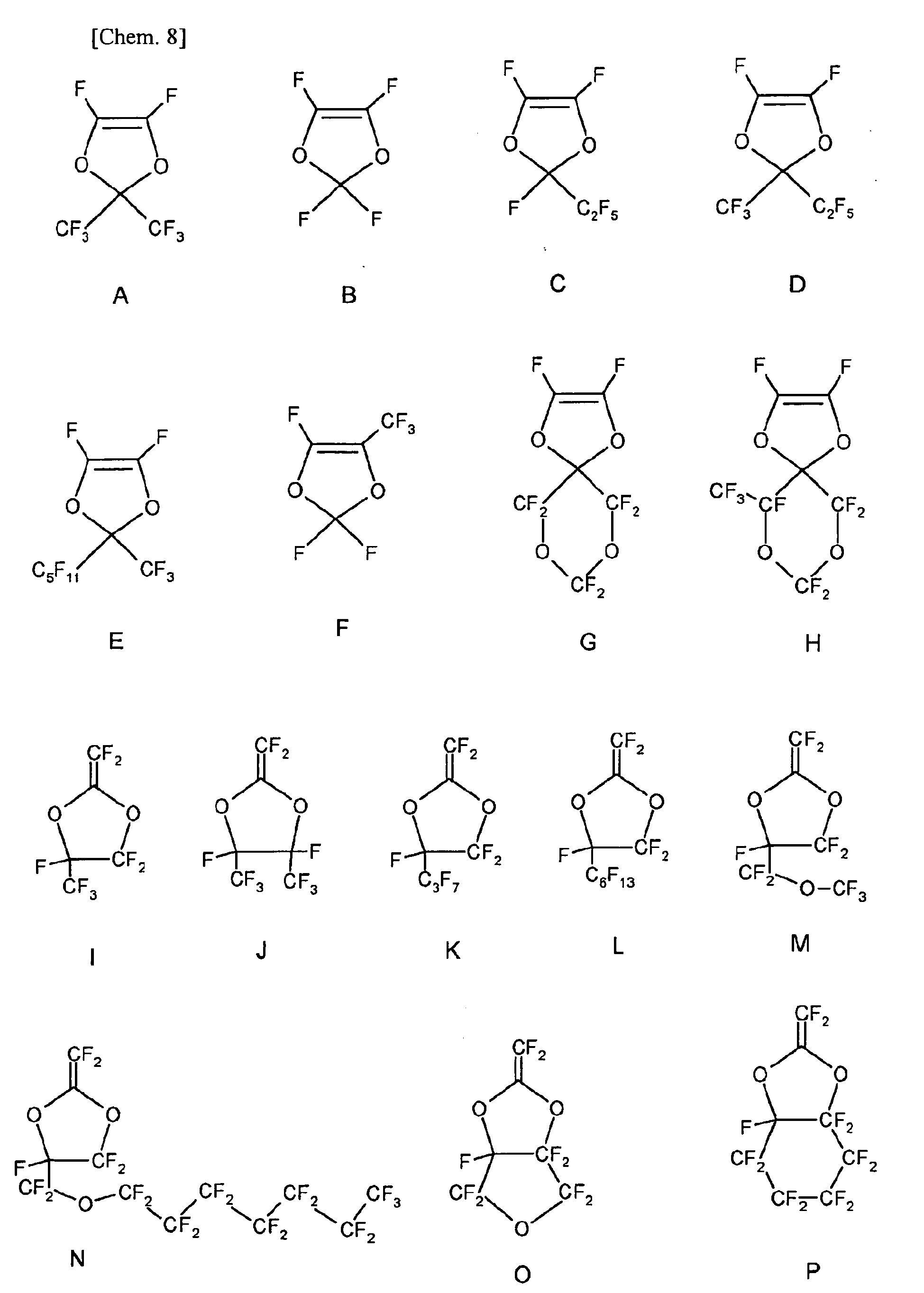

**Table 1**

| Polymer No. | Polymer composition | Compositional ratio (molar ratio) |
|---|---|---|
| 1 | A/TFE | 65/35 |
| 2 | A/BVE | 50/50 |
| 3 | B | |
| 4 | B/TFE | 75/25 |
| 5 | C | |
| 6 | D | |
| 7 | E | |
| 8 | E/TFE | 85/15 |
| 9 | F | |
| 10 | F/TFE | 48/52 |
| 11 | G | |
| 12 | H | |
| 13 | I | |
| 14 | I/TFE | 52/48 |
| 15 | I/TFE | 88/12 |
| 16 | L/PPVE | 92/8 |
| 17 | I/BVE | 57/43 |
| 18 | J | |
| 19 | K | |
| 20 | L | |
| 21 | M | |
| 22 | N | |
| 23 | O | |
| 24 | O/PPVE | 92/8 |
| 25 | P | |
| 26 | BVE | |

### [Evaluation of Water Repellency]

In Examples 1 to 25 and Comparative Example 1, a silane coupling agent solution (0.05 % by mass of ethanol solution of aminosilane) was spin coated on a silicon substrate, and a CYTOP A type 3 % by mass of perfluorotributylamine solution was then spin coated thereon. Subsequently, the silicon substrate was heated at 80°C for 90 seconds and then at 200°C for 180 seconds to form a CYTOP A layer (thickness: 150 nm). The respective water repellent composition Nos. 1 to 26 were then spin coated thereon, followed by heating at 80°C for 90 seconds and further heat-treating at 200°C for 180 seconds to dry. Thus, 1.5 µm thick layers containing the respective perfluoro polymer Nos. 1 to 26 were formed.

In Example 26, an intermediate layer (thickness: 1.5 µm) formed of the perfluoro polymer No. 26 was formed on a surface of a CYTOP A layer (thickness: 150 nm), and the water repellent composition No. 13' was then spin coated on the surface. Subsequently, the silicon substrate was heated at 80°C for 90 seconds, and then heat-treated at 200°C for 180 seconds to dry. Thus, a 150 nm thick layer containing the perfluoro polymer No. 13 was formed.

Static contact angle (contact angle of water droplet when 2 µL water droplet was formed on a substrate having a surface on which the corresponding material had been applied), dynamic sliding angle and dynamic receding angle, of the layer containing the perfluoro polymers to pure water were measured, respectively. The measurement results are shown in Table 2. In Table 2, the unit of the static contact angle, dynamic sliding angle and dynamic receding angle is all degree (°).

**Table 2**

| | Composition No. (Polymer No.) | Static contact angle | Dynamic sliding angle | Dynamic receding angle |
|---|---|---|---|---|
| Example 1 | 1 (1) | 120 | 6 | 114 |
| Example 2 | 2 (2) | 119 | 6 | 114 |
| Example 3 | 3 (3) | 118 | 7 | 113 |
| Example 4 | 4 (4) | 116 | 6 | 112 |
| Example 5 | 5 (5) | 115 | 6 | 114 |
| Example 6 | 6 (6) | 117 | 5 | 111 |
| Example 7 | 7 (7) | 115 | 6 | 113 |
| Example 8 | 8 (8) | 116 | 7 | 112 |
| Example 9 | 9 (9) | 117 | 8 | 111 |
| Example 10 | 10(10) | 115 | 6 | 113 |
| Example 11 | 11 (11) | 119 | 8 | 111 |
| Example 12 | 12 (12) | 118 | 7 | 111 |
| Example 13 | 13 (13) | 114 | 5 | 112 |
| Example 14 | 14 (14) | 117 | 5 | 113 |
| Example 15 | 15 (15) | 113 | 7 | 107 |
| Example 16 | 16 (16) | 115 | 8 | 107 |
| Example 17 | 17 (17) | 118 | 8 | 112 |
| Example 18 | 18 (18) | 114 | 6 | 112 |
| Example 19 | 19 (19) | 118 | 6 | 113 |
| Example 20 | 20 (20) | 121 | 8 | 111 |
| Example 21 | 21 (21) | 115 | 7 | 107 |
| Example 22 | 22 (22) | 120 | 13 | 105 |
| Example 23 | 23 (23) | 115 | 7 | 110 |
| Example 24 | 24 (24) | 117 | 6 | 111 |
| Example 25 | 25 (25) | 114 | 6 | 112 |
| Example 26 | 13' (13) | 118 | 5 | 116 |
| Comparative Example 1 | 26 (26) | 114 | 8 | 106 |

### [Evaluation of Irradiation Resistance to Laser Light]

Similar to the evaluation of water repellency, a CYTOP A layer and a water repellent layer containing each of the perfluoro polymer Nos. 1 to 26 were sequentially formed on a surface of a silicon substrate, and as shown in Fig. 1, about 6 ml of ultra-pure water was put onto the water repellent layer 1 to form a droplet 2 of ultra-pure water. In Example 26, the water repellent layer 1 containing the perfluoro polymer No. 13 was formed through an intermediate layer containing the perfluoro polymer No. 26, and the water droplet 2 of ultra-pure water was formed on the surface thereof. In Fig. 1, a CYTOP A layer and the intermediate layer containing the perfluoro polymer No. 26 in Example 26 were omitted.

Next, ArF excimer laser 3 (wavelength: 193 nm) was reflected by a mirror 4 to irradiate a silicon substrate 5 over the droplet 2. A region having an area of about 3 cm² was irradiated in cumulative light quantity of 0.7 kJ/cm² under the condition of from 2.6 to 2.7 mJ/cm/pulse (frequency: 110 Hz). After the irradiation, the droplet 2 of ultra-pure water was removed, and the static contact angle, dynamic sliding angle and dynamic receding angle, of the water repellent layer 1 containing the perfluoro polymer to pure water were measured, respectively. The measurement results are shown in Table 3. A CYTOP A layer (thickness: 150 nm) and a water repellent layer (thickness: 1.5 µm) containing the perfluoro polymer No. 26 were sequentially formed on a silicon substrate, and irradiated with ArF excimer layer under the same conditions without forming the droplet of ultra-pure water. The result was used as Comparative Example 2. Regarding Comparative Example 2, the static contact angle, dynamic sliding angle and dynamic receding angle to pure water were measured.

**Table 3**

| | Composition No. (Polymer No.) | Static contact angle | Dynamic sliding angle | Dynamic receding angle |
|---|---|---|---|---|
| Example 1 | 1 (1) | 115 | 8 | 111 |
| Example 2 | 2 (2) | 114 | 10 | 112 |
| Example 3 | 3 (3) | 112 | 11 | 108 |
| Example 4 | 4 (4) | 113 | 9 | 111 |
| Example 5 | 5 (5) | 112 | 8 | 113 |
| Example 6 | 6 (6) | 118 | 10 | 108 |
| Example 7 | 7 (7) | 113 | 9 | 102 |
| Example 8 | 8 (8) | 113 | 9 | 111 |
| Example 9 | 9 (9) | 114 | 11 | 112 |
| Example 10 | 10 (10) | 112 | 10 | 113 |
| Example 11 | 11 (11) | 113 | 9 | 104 |
| Example 12 | 12(12) | 115 | 9 | 112 |
| Example 13 | 13 (13) | 115 | 7 | 110 |
| Example 14 | 14 (14) | 113 | 9 | 102 |
| Example 15 | 15 (15) | 118 | 10 | 108 |
| Example 16 | 16 (16) | 118 | 8 | 110 |
| Example 17 | 17 (17) | 113 | 9 | 104 |
| Example 18 | 18 (18) | 115 | 9 | 112 |
| Example 19 | 19 (19) | 115 | 9 | 112 |
| Example 20 | 20 (20) | 118 | 10 | 108 |
| Example 21 | 21 (21) | 113 | 9 | 111 |
| Example 22 | 22 (22) | 117 | 9 | 104 |
| Example 23 | 23 (23) | 112 | 10 | 112 |
| Example 24 | 24 (24) | 110 | 9 | 112 |
| Example 25 | 25 (25) | 112 | 9 | 110 |
| Example 26 | 13' (13) | 119 | 6 | 115 |
| Comparative Example 1 | 26 (26) | 52 | 22 | 35 |
| Comparative Example 2 | 26 (26) | 115 | 4 | 112 |

Similarly, a CYTOP A layer and a water repellent layer containing each of the perfluoro polymer Nos. 1, 2 and 13 to 17 were sequentially formed on a surface of a silicon substrate, and as shown in Fig. 1, about 6 ml of ultra-pure water was put onto the water repellent layer 1 containing the perfluoro polymer to form a droplet 2 of ultra-pure water. In Example 34, the water repellent layer containing the perfluoro polymer No. 13 was formed through an intermediate layer containing the perfluoro polymer No. 26, and the water droplet 2 of ultra-pure water was formed thereon.

Next, ArF excimer laser 3 (wavelength: 193 nm) was reflected by a mirror 4 to irradiate a silicon substrate 5 over the droplet 2. A region having an area of about 3 cm² was irradiated in cumulative light quantity of 2 kJ/cm² under the condition of from 2.6 to 2.7 mJ/cm/pulse (frequency: 110 Hz). After the irradiation, the droplet 2 of ultra-pure water was removed, and the static contact angle, dynamic sliding angle and dynamic receding angle, of the water repellent layer 1 containing the perfluoro polymer to pure water were measured, respectively. The measurement results are shown in Table 4.

**Table 4**

| | Composition No. (Polymer No.) | Static contact angle | Dynamic sliding angle | Dynamic receding angle |
|---|---|---|---|---|
| Example 27 | 1 (1) | 114 | 9 | 110 |
| Example 28 | 2 (2) | 114 | 10 | 111 |
| Example 29 | 13 (13) | 113 | 9 | 109 |
| Example 30 | 14 (14) | 114 | 7 | 108 |
| Example 31 | 15 (15) | 115 | 9 | 102 |
| Example 32 | 16 (16) | 117 | 10 | 107 |
| Example 33 | 17 (17) | 117 | 8 | 109 |
| Example 34 | 13' (13) | 114 | 5 | 108 |

The following facts are seen from Table 3. In Comparative Example 2 in which the water repellent layer containing the perfluoro polymer No. 26 obtained by homopolymerization of BVE was irradiated with ArF excimer laser in dry environment without forming a droplet of ultra-pure water, large variations are not seen in any value of the static contact angle, dynamic sliding angle and dynamic receding angle, and sufficient water repellency is maintained. However, in Comparative Example 1 in which a droplet of ultra-pure water was formed on the water repellent layer 1 containing the perfluoro polymer No. 26, and the water repellent layer 1 was irradiated with laser through the droplet, it is seen that all of values of the static contact angle, dynamic sliding angle and dynamic receding angle greatly vary, and water repellency is considerably decreased. On the other hand, in Examples 1 to 26 in which the water repellent layer 1 was formed by the composition of the present invention, even in the case that the water repellent layer 1 was irradiated with laser through the droplet 2 of ultra-pure water, large variations are not seen in any value of the static contact angle, dynamic sliding angle and dynamic receding angle, and sufficient water repellency is maintained. That is, it is seen that the water repellent layer 1 has excellent irradiation resistance and shows small decrease in water repellency by laser irradiation in the presence of ultra-pure water. Specifically, the receding contact angle (to pure water) of the water repellent layer after irradiation with ArF excimer laser (wavelength: 193 nm) in cumulative light quantity of 0.7 kJ/cm² through pure water is 95° or more. Thus, the water repellent layer has excellent light resistance.

The following facts are seen from Table 4. In Examples 27 to 34 in which a water repellent layer containing each of the perfluoro polymer Nos. 1 and 2 obtained by copolymerizing PDD represented by the formula A with TFE or BVE, or containing each of the perfluoro polymer Nos. 13 to 17 obtained by homopolymerizing MMD represented by the formula I or copolymerizing MMD with TFE, BVE or PPVE was formed, even in the case that the water repellent layer was further irradiated with laser in high light quantity through the droplet of ultra-pure water, large variations are not seen in any value of the static contact angle, dynamic sliding angle and dynamic receding angle, and sufficient water repellency is maintained. It is therefore seen that the water repellent layer has irradiation resistance over a longer period of time.

Although the present invention has been described in detail and by reference to the specific embodiments, it is apparent to one skilled in the art that various modifications or changes can be made without departing the spirit and scope of the present invention.
This application is based on Japanese Patent Application No. 2009-202017 filed on September 1, 2009, the disclosure of which is incorporated herein by reference.

### Industrial Applicability

According to the present invention, a composition capable of forming a lyophobic film having good liquid repellency, particularly dynamic liquid repellency, high permeability of an exposure beam and excellent irradiation resistance, can be obtained. By using the composition, a lyophobic layer having good liquid repellency, particularly dynamic liquid repellency, high permeability of an exposure beam, excellent irradiation resistance, and free of the decrease in liquid repellency by irradiation of an exposure beam, can be formed on the surface of a component member of a liquid immersion exposure apparatus, particularly various sensors of alignment optical system and measurement stage. As a result, a liquid immersion lithography method can stably be carried out.

### Reference numerals and signs

- 1:: Water repellent layer
- 2:: Droplet
- 3:: ArF excimer laser
- 4:: Mirror
- 5:: Silicon substrate

## Claims

1. A coating material composition for a liquid immersion exposure apparatus, which is used for the purpose of forming a lyophobic layer on a surface of a component member of the liquid immersion exposure apparatus which performs a light exposure of a substrate by irradiating with an exposure beam through a liquid,
wherein the composition comprises a fluorine-containing polymer which has, in the main chain, a repeating unit that has a fluorine-containing aliphatic ring structure containing two or three etheric oxygen atoms which are not adjacent to each other, in the ring structure.

2. The coating material composition for a liquid immersion exposure apparatus according to claim 1, wherein the fluorine-containing polymer is a polymer containing a repeating unit derived from a fluorine-containing compound represented by the following formula (b1) or a fluorine-containing compound represented by the following formula(b2): 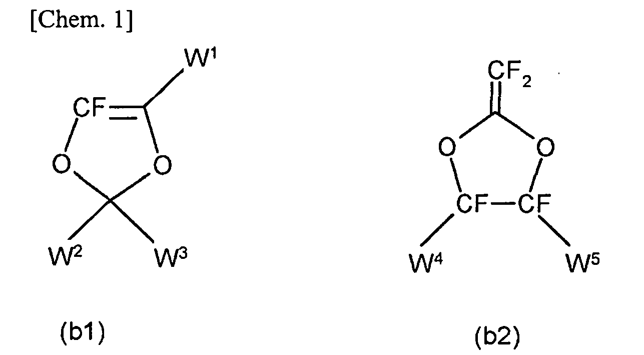 (In the formulae, W¹ represents a fluorine atom, or a perfluoroalkyl group or perfluoroalkoxy group having from 1 to 3 carbon atoms; W² and W³ each independently represent a fluorine atom, or a perfluoroalkyl group having from 1 to 6 carbon atoms, which may contain an oxygen atom; a ring structure may be formed by W² and W³; W⁴ and W⁵ each independently represent a fluorine atom, or a perfluoroalkyl group having from 1 to 8 carbon atoms, which may contain an oxygen atom; and a ring structure may be formed by W⁴ and W⁵.).

3. The coating material composition for a liquid immersion exposure apparatus according to claim 1 or 2, containing a fluorine-based solvent which dissolves the fluorine-containing polymer.

4. The coating material composition for a liquid immersion exposure apparatus according to any one of claims 1 to 3, wherein the liquid is water and the lyophobic layer is a water repellent layer.

5. The coating material composition for a liquid immersion exposure apparatus according to any one of claims 1 to 4, wherein the exposure beam is ArF excimer laser having a wavelength of 193 nm.

6. A laminate formed on a surface of a component member of a liquid immersion exposure apparatus which performs a light exposure of a substrate by irradiating with an exposure beam through a liquid,
wherein the laminate comprises a fluorine-containing polymer which has, in the main chain, a repeating unit that has a fluorine-containing aliphatic ring structure containing two or three etheric oxygen atoms which are not adjacent to each other, in the ring structure.

7. The laminate according to claim 6, further comprising a layer containing a fluorine-containing polymer having at least one functional group, formed on the surface of the component member.

8. The laminate according to claim 6 or 7, wherein the fluorine-containing polymer having, in the main chain, a repeating unit having a fluorine-containing aliphatic ring structure is a polymer containing a repeating unit derived from a fluorine-containing compound represented by the following formula (b1) or a fluorine-containing compound represented by the following formula (b2): 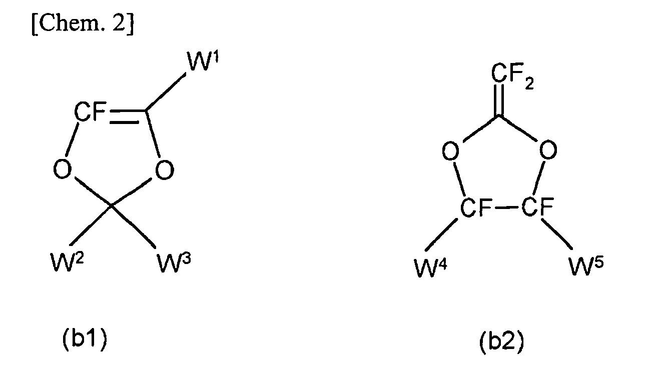 (In the formulae, W¹ represents a fluorine atom, or a perfluoroalkyl group or perfluoroalkoxy group having from 1 to 3 carbon atoms; W² and W³ each independently represent a fluorine atom, or a perfluoroalkyl group having from 1 to 6 carbon atoms, which may contain an oxygen atom; a ring structure may be formed by W² and W³; w⁴ and W⁵ each independently represent a fluorine atom, or a perfluoroalkyl group having from 1 to 8 carbon atoms, which may contain an oxygen atom; and a ring structure may be formed by W⁴ and W⁵.).

9. The laminate according to any one of claims 6 to 8, wherein the liquid is water.

10. The laminate according to any one of claims 6 to 9, wherein the exposure beam is ArF excimer laser having a wavelength of 193 nm.

11. A method for forming a laminate on a surface of a component member of a liquid immersion exposure apparatus which performs a light exposure of a substrate by irradiating with an exposure beam through a liquid, the method comprising:
a step of applying a pre-treatment to the surface of the component member;
a step of forming a second layer containing a fluorine-containing polymer having at least one functional group on the surface of the component member having been subjected to the pre-treatment; and
a step of forming a first layer on the second layer by applying the coating material composition for a liquid immersion exposure apparatus according to any one of claims 1 to 3.

12. A liquid immersion exposure apparatus which performs a light exposure of a substrate by irradiating with an exposure beam through a liquid, wherein the apparatus comprises the laminate according to any one of claims 6 to 10 on a surface of a component member.
